Europäisches Patentamt

(19) European Patent Office

Office européen des brevets

(11) **EP 0 611 739 B1**

(12) ## EUROPEAN PATENT SPECIFICATION

(45) Date of publication and mention
of the grant of the patent:
**14.01.1998 Bulletin 1998/03**

(51) Int. Cl.$^6$: **C04B 35/58**, H01L 21/48,
C04B 35/596

(21) Application number: **94200366.6**

(22) Date of filing: **11.02.1994**

(54) **Ceramic body**

Keramischer Körper

Corps céramique

(84) Designated Contracting States:
**DE FR GB NL**

(30) Priority: **18.02.1993 EP 93200467**

(43) Date of publication of application:
**24.08.1994 Bulletin 1994/34**

(73) Proprietor:
**Philips Electronics N.V.
5621 BA Eindhoven (NL)**

(72) Inventors:
• **Groen, Wilhelm Albert, c/o Int. Octrooibureau B.V.
NL-5656 AA Eindhoven (NL)**
• **Kraan,Marcellinus J., c/o Int. Octrooibureau B.V.
NL-5656 AA Eindhoven (NL)**

• **De With, Gijsbertus, c/o Int. Octrooibureau B.V.
NL-5656 AA Eindhoven (NL)**

(74) Representative:
**van der Veer, Johannis Leendert et al
International Octrooibureau B.V.,
Prof. Holstlaan 6
5656 AA Eindhoven (NL)**

(56) References cited:
**EP-A- 0 100 380**

• **JOURNAL OF THE EUROPEAN CERAMIC
SOCIETY, vol.12, no.5, 1993, BARKING, ESSEX,
GB pages 413 - 420, XP414130 W.A. GROEN ET
AL. 'Preparation, microstructure and properties
of MgSiN2 ceramics'**

## Description

The invention relates to a ceramic body. The invention also relates to a method of manufacturing a ceramic body.

Ceramic bodies have particular properties rendering them suitable for many applications. For example, ceramic bodies in the form of blocks or rods are available, for example, for use as refractory materials. A very important further use of ceramic bodies is their application as carriers or substrates. These substrates generally consist of a thin layer of sintered ceramic material, such as aluminium oxide ($Al_2O_3$), magnesium oxide (MgO), beryllium oxide (BeO), aluminium nitride (AlN) or silicon carbide (SiC). By virtue of their favourable electrically insulating properties such substrates are used in passive and active electrical components, such as resistors, capacitors, transformers and power transistors.

The known ceramic bodies generally exhibit a combination of a number of favourable and a number of unfavourable properties. For example, substrates of relatively impure aluminium oxide and magnesium oxide have the advantage that they are cheap. However, such substrates exhibit a rather poor heat conduction. Due to this poor heat conduction they are unsuitable for use as substrate material in electrical components in which a high development of heat occurs, which heat must be dissipated *via* the substrate. A further disadvantage of these oxidic ceramic materials is that they have a relatively high coefficient of expansion, rendering them less suitable for a number of applications, in particular in the field of silicon semiconductor technology. The coefficient of expansion of silicon ranges from 4 to 5.

Beryllium oxide, aluminium nitride and silicon carbide have a much higher heat conduction than aluminium oxide and magnesium oxide and, hence, can more suitably be used as a heat-dissipating substrate or "heat sink" of an electrical component. In addition, ceramic bodies of aluminium nitride and silicon carbide have a coefficient of expansion which corresponds more to that of silicon, so that they are more suitable for use as substrates in the silicon semiconductor technology. However, the ceramic aluminium nitride technology is difficult due to the poor reproducibility and problems relating to purity. As a result, ceramic substrates of pure aluminium nitride are relatively expensive. Ceramic substrates of silicon carbide are also relatively expensive because the material is difficult to process. In addition, ceramic silicon carbide has a relatively high dielectric constant, so that this material is relatively unsuitable for use as a substrate in electrical components. Finally, ceramic bodies of beryllium oxide have the important disadvantage that they are toxic.

It is an object of the invention to provide a ceramic body which combines a relatively good heat conduction with a relatively simple and inexpensive process technology. The intended ceramic body should exhibit, on the one hand, a considerably higher heat conduction and a lower coefficient of expansion than impure aluminium oxide and magnesium oxide. On the other hand, the manufacture of the intended ceramic body must be simpler and considerably cheaper than that of ceramic aluminium nitride. The ceramic body in accordance with the invention must further have a relatively low dielectric constant.

These and other objects of the invention are achieved by a densified sintered or hot-pressed ceramic body which is characterized according to the invention in that the body consists of 20-30 at. % of magnesium, 20-30 at. % of silicon, 40-60 at. % of nitrogen, maximally 15 at. % of oxygen, and, optionally, relatively small quantities of other elements, such as Ca and Be, the composition existing of 21,5 at. % of silicon, 29,9 at. % of magnesium and 48.6 at. % of nitrogen being disclaimed.

In comparison with the customary aluminium oxide and magnesium oxide, a ceramic body of the above composition has a relatively high heat conduction. Further, the coefficient of expansion of the inventive material is much lower than that of the said oxidic ceramic bodies. The manufacture of the material in accordance with the invention is very reproducible and, in comparison with aluminium nitride and silicon carbide, relatively inexpensive. In contrast with aluminium nitride, the ceramic body in accordance with the invention further exhibits a satisfactory resistance to superalkaline solutions. The inventive ceramic body further exhibits a relatively low rigidity, a good resistance to thermal shocks and a relatively low dielectric constant.

In addition to the above-mentioned constituent elements Mg, Si, N and O, the ceramic body in accordance with the invention may comprise other elements, such as Ca and Be. The mechanical and electrical properties of the ceramic body can be influenced by incorporating relatively small quantities of said elements. It has been found, however, that in ceramic bodies which comprise less than 20 at. % or more than 30 at. % of magnesium or silicon, the quantity of different-phase material is so large that the mechanical and electrical properties of such ceramic bodies are unacceptably bad. If the oxygen content in the ceramic body is in excess of 15 at. %, the heat conduction is insufficient for the intended application.

EP-A-100 380 discloses tools for the plastic deformation of non-ferrous metals and alloys. These tools are essentially composed of $Si_3N_4$ which may - amongst many other additions - contain $Mg_3N_2$ in an amount of maximally 50 percent by weight. This prior art document does not disclose or suggest a ceramic body having a composition according to claim 1 of the invention. It moreover does not disclose the use of such materials as electrical component substrate having a good thermal conductivity.

A preferred embodiment of the ceramic body in accordance with the invention is characterized in that the composition of the body corresponds to the formula $MgSiN_{2-x}O_x$, where x is smaller than 0.5. Ceramic bodies of this composition exhibit the highest heat conduction. This can be attributed to the absence of heterogeneous dopants in the ceramic body, which promote the formation of poorly heat-conducting side phases. A small deviation from the ratio Mg:Si:N+O = 1:1:2 is possible *per se* due to the presence of small quantities of second phase on the grain boundaries. However, the deviation from the stoichiometric composition never exceeds 5 at. % per element. It is assumed that ceramic materials having such a small deviation from the stoichiometric ratio satisfy the composition of the said formula.

It has been found that the quantity of oxygen present in the ceramic body is inversely proportional to the heat conduction of said body. Therefore, the aim is to minimize the quantity of oxygen in the ceramic body. Preferably, the ceramic body contains less than 10 at. % of oxygen. An even higher heat conduction is attained if the ceramic body in accordance with the invention contains less than 5 at. % of oxygen.

The invention also relates to methods of manufacturing a ceramic body. A first method is characterized in that a magnesium-silicon-nitride powder comprising 20-30 at. % of magnesium, 20-30 at. % of silicon, 40-60 at. % of nitrogen and maximally 15 at. % of oxygen is densified into a moulded product which is subsequently sintered into a ceramic body in an inert atmosphere at a temperature in the range from 1400-1600°C. A second method is characterized in that a magnesium-silicon-nitride powder comprising 20-30 at. % of magnesium, 20-30 at. % of silicon, 40-60 at. % of nitrogen and maximally 15 at% of oxygen is hot-pressed at a temperature in the range from 1400-1600°C. A preferred embodiment of this inventive method is characterized in that the composition of the powder corresponds to the formula $MgSiN_{2-x}O_x$, where x is smaller than 0.5. It is noted that the preparation of a powder of $MgSiN_2$ as well as the crystal structure of this compound are known *per se* from Bull. Soc. fr. Mineral. Cristallogr. 93 153-159 (1970).

It has been found that ceramic bodies manufactured by the method in accordance with the invention are substantially completely densified in the sintering process. The relative density of the ceramic bodies is 95% or more. By means of (isostatic) pressing or colloidal filtration the powder can be densified into a moulded product. Preferably argon is used as the inert gas. The ceramic body in accordance with the invention is preferably in the form of ⟨an electrical component⟩ substrate. The highest densities are obtained by hot-pressing, which yields densities of 99% or more.

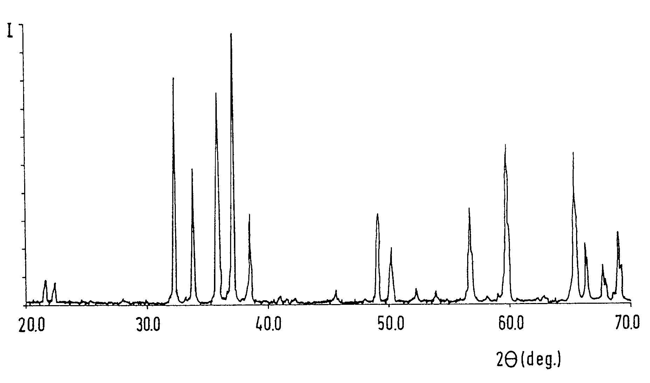

The invention will be explained in greater detail by means of an exemplary embodiment and the drawing, in which

The sole Figure shows an X-ray diffraction pattern of a ceramic body in accordance with the invention.

A stoichiometric mixture of $Mg_3N_2$ powder (Cerac, 99.9% pure) and amorphous $Si_3N_4$ powder (Sylvania, Sn 402) were thoroughly mixed and subsequently placed in an aluminium oxide crucible. The crucible was properly closed to preclude evaporation of $Mg_3N_2$. The crucible including its contents was subjected to a thermal treatment under a nitrogen atmosphere for 16 hours at 1250°C. After cooling, the mixture was ground in a ball mill, while excluding oxygen, until an average particle size of the material of approximately 1 micrometer was obtained. From the X-ray diffraction pattern (not shown) it could be derived that the powder consisted of substantially pure single-phase $MgSiN_2$, in which a small quantity of MgO and $\alpha$-$Si_3N_4$ were present as side phases. The presence of oxygen is probably caused by contamination of the amorphous $Si_3N_4$.

By means of densification, the powder was converted into moulded products. Two densification methods were used. In accordance with the first method, a pellet having a thickness of 30 nm and a cross-section of 6 nm was manufactured. In this method, a quantity of powder was isostatically compressed in two steps at a pressure of 5 and 200 MPa, respectively, at room temperature. The density of the moulded product was 50% of the theoretically maximum density. In accordance with a second method, a thin substrate having a thickness of 2 mm was manufactured. In this method a quantity of the powder obtained was dispersed in alcohol after which the dispersion was drawn off on to a filter. The layer thus formed was subsequently dried at a relatively high temperature and sub-atmospheric pressure. The density of the moulded product was approximately 50% of the theoretically maximum density.

The moulded products thus manufactured were placed in an Mo crucible which further contained a quantity of the above-mentioned powder. The crucible was then filled with argon and closed. Subsequently, the crucible was heated for 5 hours to a temperature of 1550°C and subsequently cooled. The warming-up rate was 1000°C and the cooling rate was 200°C.

The composition of the sintered moulded products was subsequently determined by means of an element analysis. The composition corresponded to the formula $Mg_{1.00}Si_{0.97}N_{1.77}O_{0.19}$. The density of the ceramic body was 3.11 g/cm$^3$. On the basis of a calculated theoretically maximum density of 3.128 g/cm$^3$, this means that the ceramic body in accordance with the invention had a density of 99.4%.

In another experiment a ceramic body of $MgSiN_2$ was manufactured by means of hot-pressing. In this experiment the same powder as in the above-mentioned experiments was used. This powder was introduced into a hot press (HP20; Thermal Technology Ind.) comprising a graphite mould. Sintering was preformed by pressing the powder at a temperature in the range from 1400-1600°C under a pressure of 75 MPa for 2 hours. The density of the sintered material was 99.6% of the theoretically maximum density.

The X-ray diffraction spectrum of a ceramic body in accordance with the invention is shown in the Figure. From this spectrum it can be derived that the ceramic body was substantially monophase and that a small quantity of $Mg_2SiO_4$ and $\beta$-$Si_3N_4$ was present in the ceramic body. The quantity thereof was less than 5 at.%.

TABLE

|  | $MgSiN_2$ | $Al_2O_3$ | AlN |
|---|---|---|---|
| $\sigma$(MPa) | 240-270 | 450 | 340 |
| E(GPa) | 235 | 398 | 315 |
| $\nu$ (-) | 0.232 | 0.235 | 0.245 |
| $\alpha$ ($10^{-6}K^{-1}$) | 5.8 | 7.9 | 4.8 |
| $\kappa$ (W/m·K) | 17 | 10 | 150 |
| R (K) | 130-150 | 110 | 170 |
| R' (kW/m) | 2.2-2.5 | 2.2 | 2.5 |
| $K_{1c}$(MPa-$m^{1/2}$) | 3.2-4.3 | 4-5 | 2.7 |
| H(GPa) | 14.2-15.9 | 19.5 | 12 |

In addition to properties of the known ceramic materials aluminium oxide and aluminium nitride, the Table also lists a number of properties of the ceramic body in accordance with the invention. The measured properties relate to the strength $\sigma$, the Young's modulus E, the transverse contraction constant $\nu$, the thermal coefficient of expansion $\alpha$, the coefficient of thermal conduction k, the resistance to fracture or tearing strength $K_{1c}$, and the hardness H. The parameters R and R' are defined by $R = (1-\nu)\sigma/E.\alpha$ and $R' = k.R$. These parameters indicate the thermal shock resistance to substantial heat transfer (R)and moderate heat transfer (R'), respectively.

Consequently, the ceramic body in accordance with the invention combines a number of satisfactory properties. On the one hand, the coefficient of expansion of the body in accordance with the invention is lower than that of the cheap aluminium oxide. On the other hand, the processing of the ceramic body in accordance with the invention is simpler and cheaper than that of aluminium nitride.

## Claims

1.  A densified sintered or hot-pressed ceramic body, characterized in that the body consists of 20 - 30 at.% of magnesium, 20 - 30 at. % of silicon, 40 - 60 at. % of nitrogen, maximally 15 at. % of oxygen, and, optionally, relatively small quantities of other elements, such as calcium and beryllium, the composition existing of 21.5 at.% of silicon, 29.9 at.% of magnesium and 48.6 at. % of nitrogen being disclaimed.

2.  A ceramic body as claimed in Claim 1, characterized in that the composition of the body corresponds to the formula $MgSiN_{2-x}O_x$, where x is smaller than 0.5.

3.  A ceramic body as claimed in Claim 1 or 2, which body is in the form of 〈an electrical component〉 substrate.

4.  A method of manufacturing a ceramic body as claimed in Claim 1, 2 or 3, characterized in that a magnesium-silicon-nitride powder comprising 20-30 at. % of magnesium, 20-30 at. % of silicon, 40-60 at. % of nitrogen and maximally 15 at. % of oxygen is densified into a moulded product which is subsequently sintered into a ceramic body in an inert atmosphere at a temperature in the range from 1400-1600°C.

5.  A method of manufacturing a ceramic body as claimed in Claim 1, 2 or 3, characterized in that a magnesium-silicon-nitride powder comprising 20-30 at. % of magnesium, 20-30 at. % of silicon, 40-60 at. % of nitrogen and maximally 15 at. % of oxygen is hot-pressed at a temperature in the range from 1400-1600°C.

6.  A method as claimed in Claim 5, characterized in that the composition of the powder corresponds to the formula $MgSiN_{2-x}O_x$, where x is smaller than 0.5.

## Patentansprüche

1.  Verdichtet gesinterter oder heißgepreßter keramischer Körper, dadurch gekennzeichnet, daß der Körper aus 20-30 At% Magnesium, 20-30 At% Silizium, 40-60 At% Stickstoffund maximal 15 At% Sauerstoffbesteht, und ggf; aus relativ geringen Mengen anderer Elemente, wie Calcium und Beryllium, wobei auf die Zusammensetzung aus 21,5 At% Silizium, 29,9 At% Magnesium und 48,6 At% Stickstoff verzichtet wird.

2.  Keramischer körper nach Anspruch 1, dadurch gekennzeichnet, daß die Zusammensetzung des Körpers der Formel $MgSiN_{2-x}O_x$ entspricht, wobei x kleiner ist als 0,5.

3.  Keramischer Körper nach Anspruch 1 oder 2, wobei dieser Körper in Form eines elektrischen Komponentensubstrats ist.

4.  Verfahren zum Herstellen eines keramischen Körpers nach Anspruch 1, 2 oder 3, dadurch gekennzeichnet, daß ein Magnesium-Silizium-Nitridpulver, das 20-30 At% Magnesium, 20-30 At% Silizium, 40-60 At% Stickstoff und maximal 15 At% Sauerstoff enthält, zu einem Formteil verdichtet wird, der daraufhin in einer inerten Atmosphäre bei einer Temperatur in der Strecke von 1400 - 1600°C zu einem Keramikkörper gesintert wird.

5. Verfahren zum Herstellen eines keramischen Körpers nach Anspruch 1, 2 oder 3, dadurch gekennzeichnet, daß ein Magnesium-Silizium-Nitridpulver, das 20-30 At% Magnesium, 20-30 At% Silizium, 40-60 At% Stickstoffund maximal 15 At% Sauerstoff enthält, bei einer Temperatur in der Strecke von 1400 - 1600°C heißgepreßt wird.

6. Verfahren na.5, dadurch gekennzeichnet, daß die Zusammensetzung des Pulvers der Formel $MgSiN_{2-x}O_x$ entspricht, wobei x kleiner ist als 0,5.

d'azote et tout au plus 15% en atomes d'oxygène est pressée à chaud à une température comprise entre 1400°C et 1600°C.

6. Procédé selon la revendication 5, caractérisé en ce que la composition de la poudre correspond à la formule $MgSiN_{2-x}O_x$ où x est inférieur à 0,5.

**Revendications**

1. Corps céramique densifié, fritté ou pressé à chaud, caractérisé en ce que le corps est constitué de 20 à 30% en atomes de magnésium, de 20 à 30% en atomes de silicium, de 40 à 60% en atomes d'azote, de tout au plus 15% en atomes d'oxygène et, facultativement, de quantités relativement faibles d'autres éléments, tels que du calcium et du béryllium, la composition constituée de 21,5% en atomes de silicium, de 29,9% en atomes de magnésium et de 48,6% en atomes d'azote étant non revendiquée.

2. Corps céramique selon la revendication 1, caractérisé en ce que la composition du corps correspond à la formule $MgSiN_{2-x}O_x$ où x est inférieur à 0,5.

3. Corps céramique selon la revendication 1 ou 2, ledit corps présente la forme d'un substrat de composant électrique.

4. Procédé pour fabriquer un corps céramique selon la revendication 1, 2 ou 3, caractérisé en ce qu'une poudre de magnésium, de silicium et de nitrure contenant 20 à 30% en atomes de magnésium, 20 à 30% en atomes de silicium, 40 à 60% en atomes d'azote et tout au plus 15% en atomes d'oxygène est densifiée jusqu'à un produit moulé qui est fritté subséquemment dans un corps céramique sous une atmosphère inerte à une température comprise entre 1400°C et 1600°C.

5. Procédé pour fabriquer un corps céramique selon la revendication 1, 2 ou 3, caractérisé en ce qu'une poudre de magnésium, de silicium et de nitrure contenant 20 à 30% en atomes de magnésium, 20 à 30% en atomes de silicium, 40 à 60% en atomes